(19) Europäisches Patentamt / European Patent Office / Office européen des brevets

(11) **EP 2 246 709 B1**

(12) **EUROPÄISCHE PATENTSCHRIFT**

(45) Veröffentlichungstag und Bekanntmachung des Hinweises auf die Patenterteilung:
**12.08.2015   Patentblatt 2015/33**

(51) Int Cl.:
**G01R 33/36** *(2006.01)*     **G01R 33/31** *(2006.01)*
**G01R 33/389** *(2006.01)*

(21) Anmeldenummer: **10158597.4**

(22) Anmeldetag: **31.03.2010**

(54) **Vorrichtung zur hochpräzisen Synchronisierung der NMR-Sendefrequenz auf die Resonanzfrequenz einer NMR-Linie unter Berücksichtigung einer nicht konstanten HF-Phase**

Device for extremely precise synchronisation of NMR transmission frequency to the resonance frequency of an NMR line taking into consideration a non-constant HF phase

Dispositif de synchronisation haute précision de la fréquence d'émission NMR sur la fréquence de résonance d'une ligne NMR en prenant en compte une phase HF non constante

(84) Benannte Vertragsstaaten:
**AT BE BG CH CY CZ DK EE ES FI FR GB GR HR HU IE IS IT LI LT LU LV MC MK MT NL NO PL PT RO SE SI SK SM TR**

(30) Priorität: **27.04.2009   DE 102009002676**

(43) Veröffentlichungstag der Anmeldung:
**03.11.2010   Patentblatt 2010/44**

(73) Patentinhaber: **Bruker BioSpin AG 8117 Fällanden (CH)**

(72) Erfinder:
• **Schwilch, Arthur 8610, Uster (CH)**
• **Schenkel, Michael 8344, Bäretswil (CH)**

(74) Vertreter: **Kohler Schmid Möbus Patentanwälte Partnerschaftsgesellschaft mbB Ruppmannstraße 27 70565 Stuttgart (DE)**

(56) Entgegenhaltungen:
JP-A- 3 156 394     JP-A- 61 256 244
JP-A- 2005 274 427     US-A- 5 302 899

## Beschreibung

Die vorliegende Erfindung bezieht sich auf eine Vorrichtung, die einen HF-Generator zur Erzeugung eines HF-Signals mit der Frequenz $f_{RF}$, ein NMR-Sende- und Empfangssystem sowie einen ersten Regelkreis umfasst, der eingerichtet ist zur Synchronisierung der Frequenz $f_{RF}$ mit der Resonanzfrequenz $f_0$ eines NMR-Signals mit einer gegebenen Relaxationszeit , wobei der HF-Generator eingerichtet ist zur Erzeugung einer Folge von Anregungsimpulsen (EX) der Repetitionsfrequenz $f_m$, mit der eine Kernmagnetresonanzbei der Resonanzfrequenz $f_0$ quasi-kontinuierlich (CW) angeregt werden kann, wobei die Periodenzeit $1/f_m$ viel kleiner ist als die Relaxationszeit, und der erste Regelkreises dazu eingerichtet ist, ein in den Niederfrequenz-Bereich hinunter gemischtes NMR-Signal $U_D$ dazu zu benutzen , den Wert der Sendefrequenz $f_{RF}$ oder den Wert eines $B_0$-Feldes so zu regeln, dass Frequenz und Phase des HF-Generators und des NMR-Signals möglichst genau übereinstimmen, wobei das NMR-Signal $U_D$ einen sägezahnförmigen AC-Anteil aufweist, dessen Ausprägung vom Verhältnis der Relaxationszeit zur Periodenzeit abhängt.

Eine derartige Vorrichtung ist bekannt aus der US 5,302,899 A (=Referenz [1]).

## Vorgeschichte

In der Kernresonanzspektroskopie ist es entscheidend, alle physikalisch auf die Probe einwirkenden Größen sehr genau zu stabilisieren oder mindestens zu messen und rechnerisch zu Kompensieren. Es ist dies in erster Linie die Magnetfeldstärke, aber auch weitere Größen wie Temperatur oder Druck können großen Einfluss auf das Kernresonanzspektrum haben und dessen Aussagekraft beeinträchtigen.

## Stand der Technik

Zur Stabilisierung des Magnetfeldes hat sich der Feldlock gemäß Referenz [1] etabliert.

Hierbei wird durch einen Regler, der auf eine Korrekturspule wirkt, die Magnetfeldstärke derart nachgeführt, dass eine Markersubstanz (typischerweise $D_2O$) welche durch einen spezialisierten Hochfrequenzkanal mit schnell alternierendem Sende- und Empfangsvorgang angeregt wird, in Resonanz verbleibt.

Die begrenzte Genauigkeit dieser Feldstabilisierung ist bekannt, wird aber normalerweise durch andere Instabilitäten, insbesondere Probentemperaturschwänkungen, verdeckt. Sie rührt in erster Linie von kleinen, temperaturabhängigen Phasenverschiebungen im Hochfrequenzpfad (Sender, Kabel, Probenkopf, Filter, Empfänger) des Feldlocks her und lässt sich durch manuelle Justage der Lockphase für eine kurze Zeit verbessern.

Die Probentemperatur wird typischerweise durch einen Luft- oder Stickstoff-Gasstrom stabilisiert, der an der Probe vorbeiströmt und dessen Temperatur mit einem Sensorelement (Thermoelement, PT100 oder ähnlichem) stabilisiert wird.

Der Gasstrom beim Sensorelement wird hierbei auf besser als 0.1 K genau stabilisiert, aber die Probentemperatur kann, bedingt durch verschiedene Wärmeeinträge auf den Gasstrom nach dem Sensor oder direkt auf die Probe, um mehrere Kelvin von der Sensortemperatur abweichen.

Unter den Begriffen "NMR-Thermometer" und "Chemical Shift Thermometer" ist eine Vielzahl von Markersubstanzen bekannt, die entweder der Probe beigemischt, oder getrennt in einem Zweikammer-Probenglas in den Magneten gegeben werden. Durch Auswertung der unterschiedlichen temperaturabhängigen Verschiebung zweier Resonanzlinien im Spektrum der Markersubstanz kann die Temperatur der Probe auf ca. 0.1 K genau gemessen werden.

Typischerweise wird die Markersubstanz mit dem NMR - Messkanal erfasst, was ein zeitgleiches erfassen der Markersubstanz und der Analysesubstanz unmöglich macht. Dies ist insbesondere bei Decoupling - Experimenten störend, wo sich die Probe durch die Hochfrequenzleistung des Experimentes um mehrere Kelvin aufwärmen kann.

In Referenz [2] schlägt Freeman schon 1967 vor, mittels einer Feldmodulation bei fixer Sendefrequenz gleichzeitig zwei Resonanzlinien anzuregen und die Frequenz der Feldmodulation kontinuierlich so zu verändern, dass beide Linien in Resonanz verbleiben, Die Frequenz der Feldmodulation ist nun ein Maß für die Probentemperatur und kann zur Steuerung der Temperatur des Gasstromes um die Probe eingesetzt werden.

Die Referenz [3] legt nahe, die zum Feldlock zusätzliche Resonanzlinie des Temperaturmarkers durch einen NMR-Oszillator zu detektieren. Hierfür wird durch eine selektive Verstärkung zwischen Empfangs- und Sende-Spule eine Selbstoszillation entfacht und die Differenzfrequenz zum Feldlock einem Frequenzzähler als Maß für die Probentemperatur zugeführt.

In Referenz [4] extrahiert Keiichiro die Differenzfrequenz zwischen Feldlock- und Temperaturmarker- NMR-Frequenz aus dem Ausgangssignal des Feldlock-Empfängers und regelt die Probentemperatur so, dass diese Frequenz mit einer Referenzfrequenz übereinstimmt, die die Probentemperatur vorgibt.

Die JP 61 256 244 offenbart ein Verfahren zur automatischen Berücksichtigung des Einflusses der HF-Phase auf den Synchronisationsvorgang. Dazu werden auch Phasenschieber eingesetzt.

**Die erfindungsgemäße Vorrichtung**

Die erfindungsgemäße Vorrichtung betrifft ein NMR-Sende- und Empfangssystem mit einer Vorrichtung zur Synchronisierung der NMR-Sendefrequenz auf die Resonanzfrequenz einer NMR-Linie, wobei ein schnell alternierender Sende- und Empfangsvorgang verwendet wird sowie eine Regelung, die entweder den Wert der Sendefrequenz (= Frequenzlock) oder den Wert des $B_0$-Feldes (= Feldlock) so einstellt, dass Frequenz und Phase des HF-Generators und der NMR-Linie möglichst genau übereinstimmen.

Aufgabe der vorliegenden Erfindung ist es, den Einfluss der HF-Phase auf den Synchronisationsvorgang zu berücksichtigen, um dadurch die Genauigkeit, mit der auf die Resonanzfrequenz einer NMR-Linie synchronisiert wird, zu verbessern

Erreicht wird dieses Ziel auf ebenso überraschend einfache wie wirkungsvolle Weise dadurch, dass ein zweiter Regelkreis, ein Phasenschieber und eine Signalextraktionsstufe vorgesehen sind, wobei die Signalextraktionsstufe eingerichtet ist, den sägezahnförmigen AC-Anteil des Signals $U_D$ zu extrahieren; und der zweite Regelkreis, dessen Eingangssignal aus der Signalextraktionsstufe kommt, dazu eingerichtet ist, den Phasenschieber zu steuern, die Phase des HF-Signals um den Wert $\Delta\varphi$ zu verändern, bis dieses Eingangssignal Null ist. Im NMR-Sende/Empfangssystem ist also ein Phasenschieber eingebaut, der als Stellglied eines zweiten Regelkreises dient und dessen Phase $\Delta\varphi$ derart geändert wird, dass der sägezahnförmige AC-Anteil des ungefilterten Signalgemischs aus dem Dispersionskanal als Messgrößes dse zweiten Regelkreises dient und auf Null geregelt wird.

Diese Verbesserung führt einerseits zu einer genaueren Synchronisation beim Frequenz- oder Feldlock (z.B. mit Deuterium als Markersubstanz), und anderseits zu einer erhöhten Genauigkeit der NMR-Temperaturmessung, bei der die Differenz der Resonanzfrequenzen zweier NMR-Linien mit unterschiedlichen Temperaturkoeffizienten dazu benutzt wird, den Temperaturwert der Messprobe zu ermitteln (= NMR-Thermometer). Das neue, kontinuierlich arbeitende NMR-Thermometer liefert eine deutlich verbesserte Genauigkeit gegenüber konventionellen Temperatursensoren, welche nur die Temperatur des Gasstromes messen können, mit dem die Messprobe erhitzt oder gekühlt wird.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert.

Es zeigen:

Fig.1    Feldlock entsprechend dem Stand der Technik;

Fig.2    Frequenzlock mit Phasenfehler-Kompensations-Regelkreis;

Fig.3a    HF-Signale im NMR-Lock mit Sendephase EX und Empfangsphase AQ;

Fig.3b    Phasenmodulation bedingt durch einen Phasenfehler PE im Regelkreis;

Fig.3c    Sinusschwingung zur Extraktion der Phasenmodulation;

Fig.3d    beispielhafte Form des Matched Filter Signals;

Fig.4    Feldlock mit Phasenfehler-Kompensations-Regelkreis; und

Fig.5    NMR-Thermometer aus der Kombination von Feldlock und Frequenzlock.

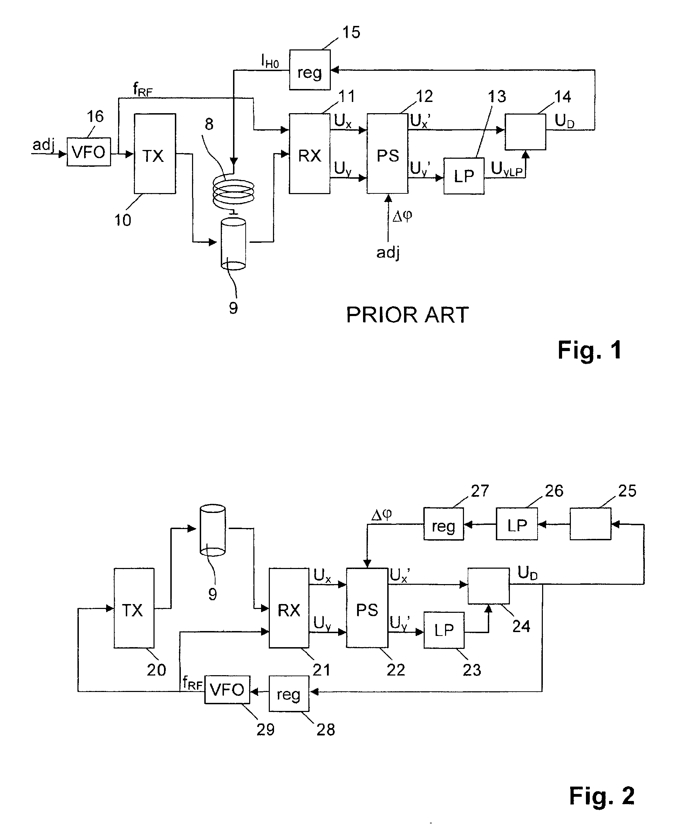

Fig.1 stellt einen Feldlock gemäß dem Stand der Technik dar:

In schneller Folge wechseln sich das Aussenden einer festen Anregungsfrequenz ($f_{RF}$) aus einem Hochfrequenzgenerator (29) durch den Sender (10) und der Empfang des NMR-Signals im Quadraturempfänger (11) ab. Die Lockphase kann mit dem Phasenschieber (12) statisch eingestellt werden. Die Division des Dispersionssignals durch dasTiefpass-gefilterte (13) Absorptionssignal ($U_x/U_{yLP}$) in der Skalierungsstufe (14) lässt den Regler (15) das Magnetfeld der Probe (9) durch den Strom ($I_{H0}$) in der Korrekturspule (8) relativ unabhängig vom Signalpegel des Empfängers (11) stabilisieren.

Fig.2 zeigt einen Frequenzlock mit Phasenfehler-Kompensations-Regelkreis:

In schneller Folge wechseln sich das Aussenden einer variablen Anregungsfrequenz ($f_{RF}$) aus einem Hochfrequenzgenerator (29) durch den Sender (20) und der Empfang des NMR-Signals im Quadraturempfänger (21) auf ebendieser Frequenz ($f_{RF}$) ab. Im Phasenschieber (22) wird die Phase ständig so geregelt, dass der sägezahnförmige AC-Anteil des Signalgemischs aus dem Dispersionskanal ($U_D$) als Messgröße des zweiten Reglers (27) dient und auf Null geregelt wird. Die Division des Dispersionssignals durch das Tiefpass-gefilterte (23) Absorptionssignal ($U_x/U_{yLP}$) in der Skalierungsstufe (24) lässt den Regler (28) die Sendefrequenz ($f_{RF}$) relativ unabhängig vom Signalpegel des Empfängers (21) auf die Resonanz einer NMR-Linie abgleichen. Die Extraktion des sägezahnförmigen AC-Anteils geschieht in optimaler Weise mit einem Matched Filter (25) mit nachgeschaltetem Tiefpass (26).

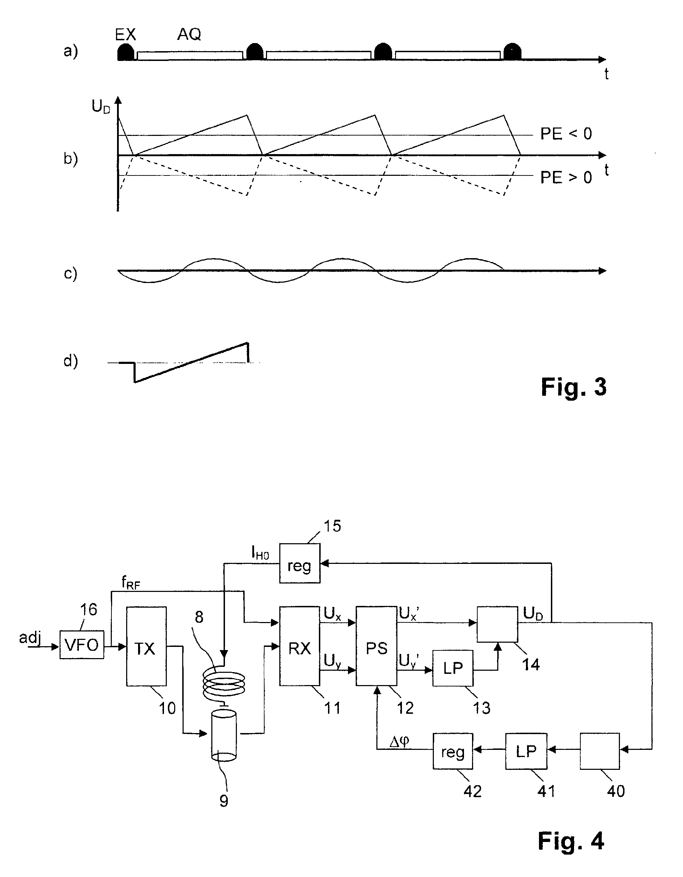

Fig.3a zeigt den zeitlichen Verlauf eines Time-Sharing Verfahrens des NMR-Lock mit Sendephase EX und Empfangsphase AQ. Die Periode beträgt etwa 150us und ist damit um viele Größenordnungen kürzer als die Relaxationszeit der Markersubstanz.

Fig.3b zeigt den zeitlichen Verlauf der Phasenmodulation bedingt durch einen Phasenfehler im Regelkreis. Die Anregungsfrequenz stellt sich so ein, dass der gemittelte Phasenoffset den Phasenfehler (PE) kompensiert.

Fig.3c zeigt den zeitlichen Verlauf einer Sinusschwingung zur Detektion (Extraktion) der Phasenmodulation.

Fig.3d zeigt eine beispielhafte Form des Matched Filter Signals zur Extraktion der Phasenmodulation im zeitlichen Verlauf.

Fig.4 zeigt einen Feldlock mit erfindungsgemäßem Phasenfehler-Kompensations-Regelkreis ähnlich jenem aus Fig.2.

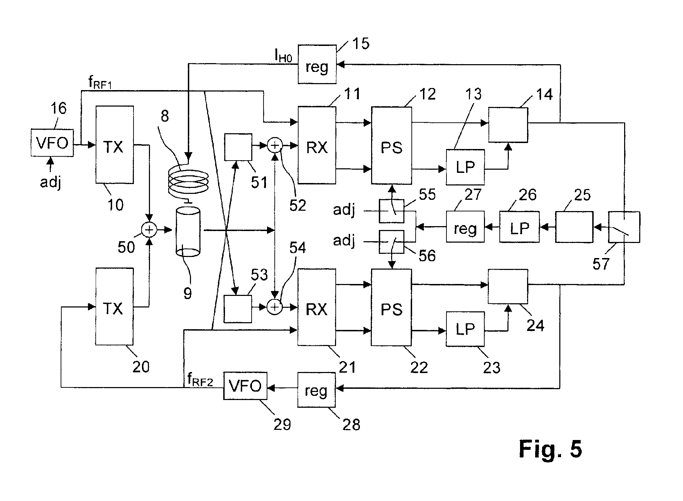

Fig.5 zeigt eine Kombination aus Feldlock (Fig.4) und Frequenzlock (Fig.2), wobei die Feldlock-NMR-Resonanz gleichzeitig als eine der beiden NMR-Resonanzlinien für die Temperaturmessung dient. Die zwei Sendersignale werden in (50) addiert und das Empfangssignal an beide Empfänger verteilt. Eine Störgrößenaufschaltung vom nicht ausgetasteten Sendersignal mittels Koppelvorrichtung vom HF-Generator (16, 29) des einen zum Empfänger (21, 11) des jeweils anderen Kanals (52,54) mit einstellbarer Amplitude und Phase (51,53) sorgt für gute Unterdrückung des Nachbarkanals. Der Phasenfehler-Kompensations-Regler ist für beide Kanäle gemeinsam ausgelegt und regelt wahlweise (57) jenen Kanal, der das bessere Signal/Rausch-Verhältnis liefert. Die Phasenkompensation des anderen Kanals wird identisch gesteuert. Jeder Kanal kann auch auf eine statisch konfigurierte Phase umgeschaltet werden (55,56).

Die schnelle, kontinuierliche und hochpräzise Messung der Resonanzfrequenz einer Markersubstanz erleichtert, oder ermöglicht erst, die Stabilisierung einer physikalischen Größe, welche das NMR-Spektrum beeinflusst, an dem Ort, wo die NMR-Messung stattfindet, nämlich in der Probe.

Der beispielsweise aus [1] bekannte NMR-Feldlock wird erfindungsgemäß um eine Kompensation der Hochfrequenzphasendrift erweitert. Außerdem wird das Prinzip auch auf die Synchronisation einer variablen Sendefrequenz auf die fixe Resonanzfrequenz einer NMR-Linie erweitert.

Da der sägezahnförmige AC-Anteil des Signals $U_D$ typischerweise viel kleiner ist als das Rauschen, wird vorzugsweise eine rausch-optimale Signalextraktion eingesetzt. Genau dies leistet ein Optimalfilter (Matched Filter) indem es das Signal mit einer Gewichtungsfunktion (Fig. 3d) multipliziert, die den normierten, charakteristischen Zeitverlauf des Signals aufweist.

Alle Komponenten eines NMR-Hochfrequenzsystems wie Sender, Kabel, Probenkopf, Filter oder Empfänger weisen eine unerwünschte, temperaturabhängige Phasendrehung auf. Typischerweise entsteht der größte Anteil davon im Resonanzkreis des Probenkopfs.

Für die normale, gepulste FT-NMR spielt diese Phasendrehung eine untergeordnete Rolle, da jedes erfasste Spektrum normalerweise vor der Auswertung phasenkorrigiert wird.

Wird aber eine NMR-Linie durch einen Regelkreis permanent in Resonanz gehalten (CW), dann ist es nicht mehr möglich, die temperaturabhängige Phasendrehung durch Analyse des Spektrums zu ermitteln.

Es ist dabei unerheblich wie die NMR-Linie in Resonanz gehalten wird: Ob durch Selbstoszillation durch Entdämpfung (siehe [3]), zeitkontinuierliches (siehe [2, 4]) oder gepulstes (siehe [1]) Senden/ Empfangen - stets verschiebt sich die Resonanzfrequenz abhängig von Phasenfehler und Linienbreite.

Hier kommt nun die Ausformung des NMR-Resonanzdetektors gemäß Referenz [1] ins Spiel. Dieser arbeitet mit einem schnellen (z.B. 6 kHz) Time-Sharing Verfahren (Fig. 3a) dergestalt, dass ein flachbucklig geformter, selektiver Anregungspuls und eine Messphase zeitlich ineinander verwoben werden. Das Umtasten zwischen Anregung und Empfang läuft um Größenordnungen schneller als die Relaxation der Markersubstanz.

Für den aus Referenz [1] bekannten Feldlock (Fig.1) wird nur der DC-Anteil des Dispersionssignals $U_D$ aus dem Empfänger (11) nach Skalierung (14) durch das Tiefpass-gefilterte (13) Absorptionssignal ($U_x/U_{yLP}$) in den Regler (15) gegeben, der das Magnetfeld der Probe (9) durch den Strom ($I_{H0}$) in der Korrekturspule (8) stabilisieren.

Wenn im Regelkreis (15) ein Phasenfehler vorhanden ist, dann versucht der Regelkreis, diesen Phasenfehler durch eine kleine Verschiebung der Anregungsfrequenz auszugleichen. Die Frequenz der NMR-Resonanz in den Sendepausen bleibt hierdurch unverändert, aber die Phase der NMR-Resonanz wird durch jeden Anregungspuls fast vollständig auf die Phase der Anregungsfrequenz synchronisiert. Während der Messphase akkumuliert sich dann mit der Rate der Differenzfrequenz eine Phasendifferenz. Dies führt zu einer sägezahnförmigen Phasenmodulation des Empfangssignals ($U_D$, Fig. 1-3). Im Mittel über die ganze Messzeit ist der Phasenfehler hierdurch genau kompensiert.

Die Phasenmodulation ist winzig klein und hängt vom Verhältnis der Repetitionsfrequenz der Anregungsimpulskette zur Linienbreite, bzw. vom Verhältnis der Relaxationszeit zum zeitlichen Abstand der Anregungspulse ab, welches per Definition einer permanent in Resonanz gehaltenen Linie groß, insbesondere >10 sein muss. Wenn aber tausende von einzelnen Modulationszyklen ausgewertet werden, dann kann die driftende Phasendrehung ermittelt und kompensiert werden.

Dass das Verfahren funktioniert ist durchaus Überraschend, wenn man sich die landläufige Erklärung für die kontinuierliche, gepulste Anregung einer NMR-Linie vor Augen hält: Das Spektrum einer Sendeimpulskette besteht aus einer Grundfrequenz und Nebenwellen im Abstand der Puls-Repetitionsfrequenz $f_m$, Da $f_m$ viel grösser als die Linienbreite sein soll, geht man gerne davon aus, dass nur die Grundfrequenz auf die NMR-Linie einwirkt. Die Grundfrequenz ist aber mathematisch und physikalisch permanent (nicht gepulst) vorhanden.

Das Dilemma löst sich erst mit der Erkenntnis auf, dass die Nebenwellen, so weit sie auch von der NMR-Linie entfernt sind, einen (permanenten) Beitrag zur Anregung der NMR-Linie leisten.

Nun da es gelingt, auch ständig in Resonanz gehaltene NMR-Linien ohne gravierenden Einfluss der Phasendrehung im Hochfrequenzpfad zu messen, erschließt sich ein Synchronisationssystem, das neben einer erfindungsgemäßen Vorrichtung A eine weitere Vorrichtung B derselben Art umfasst, wobei eine NMR-Mess-Substanz mit mindestens zwei NMR-Linien mit den Resonanzfrequenzen $f_{01}$ und $f_{02}$ mit unterschiedlichen Temperaturkoeffizienten benutzt wird, wobei die Vorrichtung A selektiv auf $f_{01}$ und die Vorrichtung B selektiv auf $f_{02}$ synchronisiert ist, und wobei die Differenzfrequenz ($f_{02} - f_{01}$) gemessen wird, um daraus den Temperaturwert der NMR-Messprobe zu ermitteln und als Temperaturwert eines NMR-Thermometers zu bezeichnen.

Ergänzt um eine Temperaturregelung ergibt sich ein Synchronisationssystem, welches den momentanen Temperaturwert des NMR-Thermometers auf einen Temperaturregler TR1 gibt, der die Temperatur eines Heiz- oder Kühlmediums, das entlang der Messprobe strömt, derart heizt oder kühlt, dass die Messprobe den vorgegebenen Temperaturwert erreicht und auf diesem bleibt.

Wenn auch schon sehr lange beispielsweise in den Referenzen [2] bis [4] vorgeschlagen, konnte sich das NMR-Thermometer zur Stabilisierung der Probentemperatur nie durchsetzen, obwohl die Temperatur nach der Magnetfeldstärke die wohl größte Fehlerquelle für NMR darstellt.

Dies lag vermutlich an der erzielbaren Genauigkeit der kontinuierlichen NMR-Probentemperaturmessung mit gängigen, bezahlbaren, ungiftigen und die NMR-Messung nicht störenden Markersubstanzen.

Die Resonanz einer idealen Markersubstanz liegt im Frequenzband des Feldlock, typischerweise also von Deuterium, wo sie keine zusätzliche Sende/Empfangs-Hardware erfordert und das NMR-Experiment nicht stört. Gut geeignet sind zum Beispiel $D_2O$ / $CD_3OD$ oder $D_2O$ / $H_2^{17}O$. Somit können beide Resonanzfrequenzen durch dieselbe Hochfrequenzelektronik verarbeitet werden. Die Differenz der Temperaturkoeffizienten dieser Substanzpaare liegt aber für einen 500 MHz Magneten unterhalb von 1Hz/K.

Die Linienbreiten der bevorzugten Markersubstanzen liegen im Bereich von 0.5Hz ($CD_3OD$) bis 3.8Hz ($D_2O$).

Wenn nun, gemäß Stand der Technik oder trivialen Variationen davon, zwei Temperaturmarkerlinien kontinuierlich angeregt und deren Resonanz gemessen wird, dann verursacht die unvermeidliche, kleine, temperaturabhängige Phasendrehung (PE) im Hochfrequenzpfad (Sender, Kabel, Probenkopf, Filter, Empfänger) eine Verschiebung der gemessenen Frequenz ($f_m$), die von der Resonanz-Linienbreite wie folgt abhängt:

$$f_m = \tan(PE) * HW/2 \qquad \text{(Halbwertsbreite HW, Phasendrehung PE)}$$

Bei unterschiedlichen Breiten der beiden Temperaturmarkerlinien entsteht ein Messfehler der Probentemperatur. Dieser beträgt beispielsweise für eine typische Phasendrehung von 20° und $D_2O$ / $CD_3OD$ etwa 0.75K.

Würden die NMR-Resonanzlinien durch zeitkontinuierliche Frequenzen angeregt, wie in den Referenzen [2] und [3] vorgeschlagen, dann wäre eine geregelte Kompensation des Phasenfehlers nicht möglich und das System hätte für viele Markersubstanzen, insbesondere die bevorzugten, deuteriumhaltigen, eine Messgenauigkeit, die kaum über jener der klassischen Gasfluss-Temperierung liegt.

In einem System, das gleichzeitig die NMR-Frequenz $f_0$ stabilisiert (Feldlock) und die Temperatur der Messprobe misst oder stabilisiert, wird vorzugsweise die Feldlock-NMR-Resonanz gleichzeitig als eine der beiden NMR-Resonanzlinien für die Temperaturmessung genutzt. (Fig.5)

Der Phasenfehler-Kompensations-Regelkreises kann im Feld- Lock Regelkreis (Fig.4) und/oder im Frequenz-Lock Regelkreis (Fig.2) angewendet werden. Vorzugsweise wird er in dem Regelkreis eingesetzt, in welchem das stärkere Signal vorhanden ist (siehe Fig.5, Umschalter 57). Solange für beide Substanzen die gleiche Hochfrequenz-Hardware eingesetzt wird, genügt ein Phasenfehler-Kompensations-Regelkreises, da beide Signale mit dem gleichen Fehler behaftet sind. Die Phasenkorrektur wird dann auf beide Kreise identisch angewendet (siehe Fig.5, Umschalter 55,56).

Wenn eine der beiden NMR-Resonanzlinien für die Temperaturmessung gleichzeitig als Feldlock dient (Fig.5) und die zweite NMR-Resonanzlinie sehr nahe bei der Feldlock- Resonanzlinie liegt, dann kann sich die Regelbandbreite des Feldlock bis in den Bereich der Temperatur-Resonanzlinie erstrecken. Insbesondere für diesen Fall wird das NMR-Thermometer ergänzt durch eine

Vorrichtung nach einem der Ansprüche 3 oder 4, **dadurch gekennzeichnet, dass** eine Koppelvorrichtung vorgesehen ist, die das Signal des HF-Generators (29, 16) der Vorrichtung A durch eine Amplituden und Phasenkorrektur (51, 53) leitet und in einem Addierer mit dem HF-Empfangssignal der Vorrichtung B derart kombiniert (52, 54), dass die dort vorhandene, störende Resonanzlinie $f_{01}$ möglichst gut unterdrückt wird.

Das NMR-Thermometer reagiert ähnlich wie der Feldlock mit Totalausfall auf Gradientenpulse für den NMR-Messkanal. Deshalb ist ein Steuereingang vorgesehen, der alle Reglersignale und Zustandsgrößen innerhalb sämtlicher Regelkreise einfriert.

Die Regelkreise werden kurz vor den Gradientenpulsen deaktiviert und nach einer gewissen Wartezeit hinter dem letzten Gradientenpuls wieder aktiviert.

Ein verbessertes Synchronisationssystem ist **dadurch gekennzeichnet, dass** der Temperaturregler TR1 nicht eingefroren wird, und dass ein Rechenwerk aus dem eingefrorenen NMR-Temperaturmesswert und aus einer Kombination von Messwerten zusätzlicher, konventioneller Temperatursensoren, welche die Temperatur des Heiz- oder Kühlmediums messen, den Eingangswert für TR1 berechnet.

Eine weitere Variante zeichnet sich dadurch aus, dass ein Regelkreis den Messwert des NMR-Thermometers mit den Messwerten zusätzlicher, konventioneller Temperatursensoren, welche die Temperatur des Heiz- oder Kühlmediums messen, derart kombiniert, dass die Messprobe schneller die gewünschte Temperatur erreicht.

Wie oben erwähnt, kann die Probentemperatur um mehrere Kelvin von der Gasstromtemperatur abweichen. Wenn aber beide Temperaturen permanent verfügbar sind, dann kann der Gasstrom auf einen kontrolliert überschwing-genden Wert geregelt werden, so dass sich eine frisch in den Magneten gegebene Messprobe schneller auf die Zieltemperatur einstellt.

Eine weitere Spielart der Erfindung ist ein Synchronisationssystem, bei welchem der momentane Temperaturwert des NMR-Thermometers einem Regler zugeführt wird, dessen Ausgangssignal die Leistung eines auf die NMR-Probe wirkenden HF-Senders derart steuert, dass die Messprobe den vorgegebenen Temperaturwert erreicht und auf diesem bleibt.

Hierbei kann eine, gegenüber der indirekten Heizung über ein Heizmedium und die Außenwand der Messprobe, wesentlich schnellere und homogenere Erwärmung der Messprobe erwartet werden. Voraussetzung hierfür ist die direkte Temperaturmessung in der Messprobe.

**Bezugszeichenliste**

| | |
|---|---|
| 10, 20 | Hochfrequenz - Sender |
| 11, 21 | Quadratur - Hochfrequenz - Empfänger |
| 16,29 | HF-Generator |
| 9 | NMR-Probe |
| 8 | Korrekturspule für das H0-Feld |
| 12, 22 | Phasenschieber |
| 13, 23, 26 | Tiefpassfilter |
| 14, 24 | Skalierung (Division $U_x$ / $U_{yLP}$) |
| 25, 40 | Matched Filter |
| 51, 53 | Amplituden- und Phasendrehungs- Stellglied |
| 15,27,28,42 | Regler |
| 50, 52, 54 | Addierer |

| 55, 56, 57 | Umschalter |
|---|---|
| AQ | Messzeit |
| EX | Anregungspuls |
| PE | Phasenfehler |
| adj | manueller Stellwert |

**Referenzliste**

[1] US 5,302,899 A
[2] US 3,502,964 A
[3] DE 30 06 148 A1
[4] JP 3-156394 A

**Patentansprüche**

1. Vorrichtung, die einen HF-Generator (16; 29) zur Erzeugung eines HF-Signals mit der Frequenz $f_{RF}$, ein NMR-Sende- (10; 20) und Empfangssystem (11; 21) sowie einen ersten Regelkreis (15; 28) umfasst, der eingerichtet ist zur Synchronisierung der Frequenz $f_{RF}$ mit der Resonanzfrequenz $f_0$ eines NMR-Signals mit einer gegebenen Relaxationszeit , wobei
der HF-Generator eingerichtet ist zur Erzeugung einer Folge von Anregungsimpulsen (EX) der Repetitionsfrequenz $f_m$, mit der eine Kernmagnetresonanz bei der Resonanzfrequenz $f_0$ quasi-kontinuierlich (CW) angeregt werden kann, wobei die Periodenzeit $1/f_m$ viel kleiner ist als die Relaxationszeit,
und der erste Regelkreises (15; 28) dazu eingerichtet ist, ein in den Niederfrequenz-Bereich hinunter gemischtes NMR-Signal $U_D$ dazu zu benutzen , den Wert der Sendefrequenz $f_{RF}$ (29) oder den Wert eines $B_0$-Feldes (8) so zu regeln, dass Frequenz und Phase des HF-Generators und des NMR-Signals möglichst genau übereinstimmen, wobei das NMR-Signal $U_D$ einen sägezahnförmigen AC-Anteil aufweist, dessen Ausprägung vom Verhältnis der Relaxationszeit zur Periodenzeit abhängt,
**dadurch gekennzeichnet,**
**dass** ein zweiter Regelkreis (27; 42), ein Phasenschieber (12; 22) und eine Signalextraktionsstufe (25, 26; 40, 41) vorgesehen sind, wobei die Signalextraktionsstufe (25, 26; 40, 41) eingerichtet ist, den sägezahnförmigen AC-Anteil des Signals $U_D$ zu extrahieren;
und der zweite Regelkreis (27; 42), dessen Eingangssignal aus der Signalextraktionsstufe (25, 26; 40, 41) kommt, dazu eingerichtet ist, den Phasenschieber (12; 22) zu steuern, die Phase des HF-Signals um den Wert $\Delta\varphi$ zu verändern, bis dieses Eingangssignal Null ist.

2. Vorrichtung nach Anspruch 1, **dadurch gekennzeichnet, dass** die Signalextraktionsstufe (25, 26; 40, 41) ein Optimalfilter ist.

3. Vorrichtung nach einem der vorgehenden Ansprüche, **dadurch gekennzeichnet, dass** ein Steuereingang vorgesehen ist, der dazu eingerichtet. ist, alle Reglersignale und Zustandsgrößen innerhalb sämtlicher Regelkreise einzufrieren.

4. Verfahren zur Temperaturmessung an einer Messprobe unter Verwendung eines Synchronisationssystems mit einer Vorrichtung A nach einem der vorhergehenden Ansprüche und einer weiteren Vorrichtung B nach einem der vorhergehenden Ansprüche, wobei in einer der beiden Vorrichtungen auf den zweiten Regelkreis zur Einstellung der Phase $\Delta\varphi$ verzichtet werden kann, sofern der Stellwert der anderen Vorrichtung auch am eigenen Phasenschieber (12; 22) anliegt, wobei in dem Verfahren eine NMR-Messsubstanz mit mindestens zwei NMR-Linien mit den Resonanzfrequenzen $f_{01}$ und $f_{02}$ mit unterschiedlichen Temperaturkoeffizienten benutzt wird, wobei die Vorrichtung A selektiv auf $f_{01}$ und die Vorrichtung B selektiv auf $f_{02}$ synchronisiert ist, und wobei das System dazu eingerichtet ist, die Differenzfrequenz $(f_{02} - f_{01})$ und daraus einen Temperaturwert der NMR-Messprobe zu ermitteln.

5. Verfahren nach Anspruch 4, **dadurch gekennzeichnet, dass** die Periodenzeit $1/f_m$ kürzer als $1/10$ der Relaxationszeit gewählt ist.

6. Verfahren nach einem der Ansprüche 4 oder 5, **dadurch gekennzeichnet, dass** das Synchronisationssystem den momentanen Temperaturwert des NMR-Thermometers auf einen Temperaturregler TR1 gibt, der die Temperatur eines Heiz- oder Kühlmediums, das entlang der Messprobe strömt, derart heizt oder kühlt, dass die Messprobe den vorgegebenen Temperaturwert erreicht und auf diesem bleibt.

7. Verfahren nach Anspruch 6, **dadurch gekennzeichnet, dass** ein Regelkreis den Messwert des NMR-Thermometers mit den Messwerten zusätzlicher, konventioneller Temperatursensoren, welche die Temperatur des Heiz- oder Kühlmediums messen, derart kombiniert, dass die Messprobe schneller die gewünschte Temperatur erreicht.

8. Verfahren nach Anspruch 7, **dadurch gekennzeichnet, dass** der Temperaturregler TR1 nicht eingefroren wird, und dass ein Rechenwerk aus dem eingefrorenen NMR-Temperaturmesswert und aus einer Kombination von Messwerten zusätzlicher, konventioneller Temperatursensoren, welche die Temperatur des Heiz- oder Kühlmediums messen, den Eingangswert für den Temperaturregler TR1 berechnet.

9. Verfahren nach einem der Ansprüche 4 oder 5, **dadurch gekennzeichnet, dass** der momentane Temperaturwert des NMR-Thermometers einem Regler zugeführt wird, dessen Ausgangssignal die Leistung eines auf die NMR-Probe wirkenden HF-Senders derart steuert, dass die Messprobe den vorgegebenen Temperaturwert erreicht und auf diesem bleibt.

10. Synchronisationssystem zur Durchführung des Verfahrens nach Anspruch 4 mit einer Vorrichtung A nach einem der Ansprüche 1 bis 3 und einer weiteren Vorrichtung B nach einem der Ansprüche 1 bis 3, wobei in einer der beiden Vorrichtungen auf den zweiten Regelkreis zur Einstellung der Phase $A\varphi$ verzichtet werden kann, sofern der Stellwert der anderen Vorrichtung auch am eigenen Phasenschieber (12; 22) anliegt, sowie mit einer NMR-Messsubstanz mit mindestens zwei NMR-Linien mit den Resonanzfrequenzen $f_{01}$ und $f_{02}$ mit unterschiedlichen Temperaturkoeffizienten, wobei die Vorrichtung A selektiv auf $f_{01}$ und die Vorrichtung B selektiv auf $f_{02}$ synchronisiert ist, und wobei das System dazu eingerichtet ist, einen Temperaturwert der NMR-Messprobe anhand der Differenzfrequenz ($f_{02}$ - $f_{01}$) zu ermitteln.

11. Synchronisationssystem nach Anspruch 10, **dadurch gekennzeichnet, dass** eine Koppelvorrichtung vorgesehen ist, die das Signal des HF-Generators (16; 29) der Vorrichtung A durch eine Amplituden- und Phasenkorrektur (51, 53) leitet und in einem Addierer (52, 54) mit dem HF-Empfangssignal der Vorrichtung B derart kombiniert, dass die dort vorhandene, störende Resonanzlinie $f_{01}$ möglichst gut unterdrückt wird.

12. Synchronisationssystem nach Anspruch 11, **dadurch gekennzeichnet, dass** eine weitere Koppelvorrichtung von der Vorrichtung B zur Vorrichtung A vorgesehen ist, welche die störende Resonanzlinie $f_{02}$ in der Vorrichtung A möglichst gut unterdrückt.

**Claims**

1. Device comprising an RF generator (16; 29) for generating an RF signal with the frequency $f_{RF}$, an NMR transmission (10; 20) and reception system (11; 21) and a first control loop (15; 28) which is designed to synchronize the frequency $f_{RF}$ with the resonance frequency $f_0$ of an NMR signal with a given relaxation time, wherein the RF generator is designed to generate a train of excitation pulses (EX) of the repetition frequency $f_m$, with which nuclear spins of the resonance frequency $f_0$ can be excited quasi-continuously (CW), wherein the period time $1/f_m$ is chosen to be much smaller than the relaxation time,
and the first control loop (15; 28) is designed to use an NMR signal $U_D$ mixed down into the low-frequency range for controlling the value of the transmission frequency $f_{RF}$ (29) or the value of a $B_0$ field (8) in such a way that the frequency and phase of the RF generator and of the NMR signal match as precisely as possible, wherein the NMR signal $U_D$ has a saw-tooth AC component, the characteristic of which depends on the ratio between the relaxation time and the period time,
**characterized in that**,
a second control loop (27; 42), a phase shifter (12; 22) and a signal extraction stage (25, 26; 40, 41) are provided, wherein the signal extraction stage (25, 26; 40, 41) is designed to extract the saw-tooth AC component of the signal $U_D$, and the second control loop (27; 42) whose input signal comes from the signal extraction stage (25, 26; 40, 41) is designed to control the phase shifter (12; 22) to change the phase of the RF signal by the value $\Delta\varphi$ until this input signal is zero.

2. Device according to claim 1, **characterized in that** the signal extraction stage (25, 26; 40, 41) is a matched filter.

3. Device according to any one of the previous claims, **characterized in that** a control input is provided that is designed to freeze all closed-loop controller signals and state variables within all control loops.

4. Method for measuring the temperature at a measurement sample using a synchronization system with a device A according to any one of the previous claims and a further device B according to any one of the previous claims, wherein one of the two devices does not have a second control loop for setting the phase $\Delta\varphi$ if the control variable of the other device is also applied to the first device's own phase shifter (12; 22), wherein the method utilizes an NMR measurement substance with at least two NMR lines with the resonance frequencies $f_{01}$ and $f_{02}$ with different temperature coefficients, wherein the device A is selectively synchronized to $f_{01}$ and the device B is selectively synchronized to $f_{02}$, and wherein the system is designed to determine the differential frequency ($f_{02} - f_{01}$) and therefrom a temperature value of the NMR measurement sample.

5. Method according to claim 4, **characterized in that** the period time $1/f_m$ is selected to be shorter than 1/10 of the relaxation time.

6. Method according to any one of claims 4 or 5, **characterized in that** the synchronization system inputs the instantaneous temperature value of the NMR thermometer to a temperature controller TR1, which heats or cools the temperature of a heating or cooling medium passing along the measurement sample such that the measurement sample reaches and remains at the defined temperature value.

7. Method according to claim 6, **characterized in that** a control loop combines the measurement value of the NMR thermometer with the measurement values of additional, conventional temperature sensors that measure the temperature of the heating or cooling medium in such a way that the measurement sample reaches the desired temperature more quickly.

8. Method according to claim 7, **characterized in that** the temperature controller TR1 is not frozen and that a computation unit calculates the input value for the temperature controller TR1 from the frozen NMR temperature measurement value and from a combination of measurement values of additional, conventional temperature sensors that measure the temperature of the heating or cooling medium.

9. Method according to any one of claims 4 or 5, **characterized in that** the instantaneous temperature value of the NMR thermometer is input to a controller whose output signal controls the power of an RF transmitter acting on the NMR sample in such a way that the measurement sample reaches and remains at the defined temperature value.

10. Synchronization system for performing the method according to claim 4 with a device A in accordance with any one of claims 1 to 3 and a further device B in accordance with any one of claims 1 to 3, wherein one of the two devices does not have a second control loop for setting the phase $\Delta\varphi$ if the control variable of the other device is also applied to the first device's own phase shifter (12; 22), as well as with an NMR measurement substance with at least two NMR lines with the resonance frequencies $f_{01}$ and $f_{02}$ with different temperature coefficients, wherein the device A is selectively synchronized to $f_{01}$ and the device B is selectively synchronized to $f_{02}$, and wherein the system is designed to determine a temperature value of the NMR measurement sample by means of the differential frequency ($f_{02}-f_{01}$).

11. Synchronization system according to claim 10, **characterized in that** a coupling device is provided that routes the signal of the RF generator (16; 29) of the device A through an amplitude and phase correction (51, 53) and combines it with the RF reception signal of the device B in an adder (52, 54) in such a way that the unwanted resonance line $f_{01}$ there is suppressed as well as possible.

12. Synchronization system according to claim 11, **characterized in that** a further coupling device is provided from device B to device A that suppresses the unwanted resonance line $f_{02}$ in the device A as well as possible.

## Revendications

1. Dispositif qui comprend un générateur HF (16 ; 29) pour générer un signal HF de fréquence $f_{RF}$, un système d'émission (10 ; 20) et de réception RMN (11 ; 21) ainsi qu'un premier circuit de régulation (15 ; 28) qui est conçu pour synchroniser la fréquence $f_{RF}$ avec la fréquence de résonance $f_0$ d'un signal RMN ayant un temps de relaxation donné, le générateur HF étant conçu pour générer une suite d'impulsions d'excitation (EX) de fréquence de répétition $f_m$,

avec laquelle une résonance magnétique nucléaire à la fréquence de résonance $f_0$ peut être excitée de façon quasi continue (CW), la période $1/f_m$ étant beaucoup plus petite que le temps de relaxation,

et le premier circuit de régulation (15 ; 28) étant conçu pour utiliser un signal RMN $U_D$ abaissé par mélange dans la gamme des basses fréquences afin de réguler la valeur de la fréquence d'émission $f_{RF}$ (29) ou la valeur d'un champ $B_0$ (8) de façon que la fréquence et la phase du générateur HF et du signal RMN coïncident le plus exactement possible, le signal RMN $U_D$ présentant une composante alternative en dents de scie dont la forme dépend du rapport entre le temps de relaxation et la période,

**caractérisé en ce**

**qu'**un deuxième circuit de régulation (27 ; 42), un déphaseur (12 ; 22) et un étage d'extraction de signal (25, 26 ; 40, 41) sont prévus, l'étage d'extraction de signal (25, 26 ; 40, 41) étant conçu pour extraire la composante alternative en dents de scie du signal $U_D$ ;

et le deuxième circuit de régulation (27 ; 42), dont le signal d'entrée vient de l'étage d'extraction de signal (25, 26 ; 40, 41), est conçu pour commander le déphaseur (12 ; 22) de façon à faire varier la phase du signal HF autour de la valeur $\Delta\varphi$ jusqu'à ce que ce signal d'entrée soit nul.

2. Dispositif selon la revendication 1, **caractérisé en ce que** l'étage d'extraction de signal (25, 26 ; 40, 41) est un filtre accordé.

3. Dispositif selon l'une des revendications précédentes, **caractérisé en ce qu'**une entrée de commande est prévue, qui est conçue pour geler tous les signaux de régulateur et grandeurs d'état dans tous les circuits de régulation.

4. Procédé de mesure de température sur un échantillon de mesure en utilisant un système de synchronisation doté d'un dispositif A selon l'une des revendications précédentes et d'un autre dispositif B selon l'une des revendications précédentes, le deuxième circuit de régulation pour régler la phase $\Delta\varphi$ pouvant être omis dans l'un des deux dispositifs si la valeur de réglage de l'autre dispositif est appliquée aussi à son propre déphaseur (12 ; 22), une substance de mesure RMN avec au moins deux lignes RMN de fréquences de résonance $f_{01}$ et $f_{02}$ avec des coefficients de température différents étant utilisée dans le procédé, le dispositif A étant synchronisé sélectivement sur $f_{01}$ et le dispositif B sélectivement sur $f_{02}$, et le système étant conçu pour déterminer la fréquence différentielle $(f_{02} - f_{01})$ et, à partir de celle-ci, une valeur de température de l'échantillon de mesure RMN.

5. Procédé selon la revendication 4, **caractérisé en ce que** la période $1/f_m$ est plus courte que 1/10 du temps de relaxation.

6. Procédé selon l'une des revendications 4 ou 5, **caractérisé en ce que** le système de synchronisation transmet la valeur de température momentanée du thermomètre RMN à un régulateur de température TR1 qui augmente ou diminue la température d'un milieu de chauffage ou de refroidissement qui s'écoule le long de l'échantillon de mesure, de façon que l'échantillon de mesure atteigne la valeur de température prédéfinie et y reste.

7. Procédé selon la revendication 6, **caractérisé en ce qu'**un circuit de régulation combine la valeur de mesure du thermomètre RMN avec les valeurs de mesure de capteurs de température conventionnels supplémentaires qui mesurent la température du milieu de chauffage ou de refroidissement de façon que l'échantillon de mesure atteigne plus rapidement la température souhaitée.

8. Procédé selon la revendication 7, **caractérisé en ce que** le régulateur de température TR1 n'est pas gelé et qu'une unité de calcul calcule la valeur d'entrée pour le régulateur de température TR1 à partir de la valeur de mesure de température RMN gelée et d'une combinaison de valeurs de mesure de capteurs de température conventionnels supplémentaires qui mesurent la température du milieu de chauffage ou de refroidissement.

9. Procédé selon l'une des revendications 4 ou 5, **caractérisé en ce que** la valeur de température momentanée du thermomètre RMN est amenée à un régulateur dont le signal de sortie commande la puissance d'un émetteur HF agissant sur l'échantillon RMN de façon que l'échantillon de mesure atteigne la valeur de température prédéfinie et y reste.

10. Système de synchronisation pour mettre en oeuvre le procédé selon la revendication 4 avec un dispositif A selon l'une des revendications 1 à 3 et un autre dispositif B selon l'une des revendications 1 à 3, le deuxième circuit de régulation pour régler la phase $\Delta\varphi$ pouvant être omis dans l'un des deux dispositifs si la valeur de réglage de l'autre dispositif est appliquée aussi à son propre déphaseur (12 ; 22), ainsi qu'avec une substance de mesure RMN avec au moins deux lignes RMN de fréquences de résonance $f_{01}$ et $f_{02}$ avec des coefficients de température différents, le dispositif A étant synchronisé sélectivement sur $f_{01}$ et le dispositif B sélectivement sur $f_{02}$, et le système étant conçu pour déterminer valeur de température de l'échantillon de mesure RMN à partir de la fréquence différentielle $(f_{02} - f_{01})$.

11. Système de synchronisation selon la revendication 10, **caractérisé en ce qu'**un dispositif de couplage est prévu, qui conduit le signal du générateur HF (16 ; 29) du dispositif A à travers une correction d'amplitude et de phase (51, 53) et le combine dans un additionneur (52, 54) avec le signal de réception HF du dispositif B de façon que la ligne de résonance $f_{01}$ perturbatrice qui y est présente soit éliminée le mieux possible.

12. Système de synchronisation selon la revendication 11, **caractérisé en ce qu'**un autre dispositif de couplage du dispositif B avec le dispositif A est prévu, lequel élimine le mieux possible la ligne de résonance $f_{02}$ perturbatrice dans le dispositif A.

PRIOR ART

**Fig. 1**

**Fig. 2**

a)

EX     AQ

t

b)

$U_D$

PE < 0

PE > 0

t

c)

d)

**Fig. 3**

15

$I_{H0}$    reg

$f_{RF}$

16

adj    VFO    TX

8

RX    $U_x$    PS    $U_x'$    $U_D$

$U_y$    $U_y'$    LP    14

10    11    12    13

9

$\Delta\varphi$    reg    LP    40

42    41

**Fig. 4**

**Fig. 5**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5302899 A
- JP 61256244 B
- US 3502964 A
- DE 3006148 A1
- JP 3156394 A